# EUROPÄISCHE PATENTSCHRIFT

(11) **EP 1 060 505 B1**
(45) Veröffentlichungstag und Bekanntmachung des Hinweises auf die Patenterteilung: **22.02.2006**
(21) Anmeldenummer: 98966374.5
(22) Anmeldetag: 19.12.1998
(51) Int. Cl.: H01L 21/268, H01L 21/04

(54) **VERFAHREN ZUR HERSTELLUNG EINES MIKROELEKTRONISCHEN HALBLEITERBAUELEMENTS**
METHOD FOR PRODUCING A MICROELECTRONIC SEMICONDUCTOR COMPONENT
PROCEDE POUR PRODUIRE UN COMPOSANT MICROELECTRONIQUE A SEMICONDUCTEUR

(30) Priorität: 27.02.1998 DE 19808246
(43) Veröffentlichungstag der Anmeldung: 20.12.2000
(73) Patentinhaber: DaimlerChrysler AG, 70567 Stuttgart (DE)
(72) Erfinder: NIEMANN, Ekkehard, D-63545 Hanau (DE); PANKNIN, Dieter, D-01277 Dresden (DE); SKORUPA, Wolfgang, D-01478 Weixdorf (DE); WIRTH, Hans, D-01326 Dresden (DE)
(86) Internationale Anmeldenummer: PCT/EP1998/008339
(87) Internationale Veröffentlichungsnummer: WO 1999/044225

(56) Entgegenhaltungen:
- EP-A- 0 399 662
- WO-A-97/39477
- DE-A- 3 139 711
- GB-A- 2 083 010
- US-A- 4 504 323
- US-A- 4 571 486

## Beschreibung

Die Erfindung betrifft ein Verfahren zur Herstellung eines mikroelektronischen Halbleiterbauelements gemäß dem Oberbegriff des unabhängigen Anspruchs.

Aus den Dokumenten GB-A-2083010, DE 3139711 1 A1, US4504323, US 4571486, EP 0399662 A2 sind jeweils Verfahren mit den Merkmalen aus dem Oberbegriff von Anspruch 1 bekannt.

Aus der WO 97/39477 ist ein Verfahren zur tonen Implantation von Siliziumkarbid bekannt.

Nach der Implantation von Dotanden bei der Herstellung von mikroelektronischen Halbleiterbauelementen weist der Halbleiter im Bereich des implantierten Volumens Strahlenschäden in Form von Gitterstörungen und Zwischengitteratomen auf. Um die kristalline Ordnung des Halbleiters wieder zu verbessern und um die implantierten Dotanden elektrisch zu aktivieren, muß der Halbleiter bei hoher Temperatur ausgeheilt werden. Die Einwirkung von hohen Temperaturen führt zu erheblichen Diffusionsvorgängen im Halbleiter. Im Falle der Dotierungen und der Ausheilung der durch die Implantation erzeugten Strahlenschäden ist dies erwünscht, jedoch sind die Beweglichkeiten aller Konstituenten des Halbleiters bei hohen Temperaturen stark erhöht, so daß unerwünschte Diffusionen anderer Komponenten stattfinden. Ein weiteres Problem ist der mögliche Verlust von Konstituenten mit hohen Partialdrücken bei den Ausheiltemperaturen mit nachteiligen Wirkungen auf elektrische oder andere Eigenschaften des Halbleiters. Insbesondere Halbleiter wie GaAs oder SiC weisen einen Schwund von Konstituenten auf, wenn erhöhte Temperaturen auf das Bauelement wirken.

Es wurde bereits in einem Artikel von S. Ahmed et al. in der Zeitschrift Applied Physics Letters, Band 66, Jahrgang 1995, S. 712ff. vorgeschlagen, Siliziumkarbid mit einem Excimerlaser hoher Energie an der Oberfläche zu erhitzen. Ein Laserstrahl hoher Energie und hoher Intensität wird über einen Siliziumkarbidkörper geführt, wobei die Oberfläche abgerastert wird. Das Verfahren hat den Nachteil, daß die Erwärmung relativ lange dauert, insbesondere beim Ausheilen ganzer Halbleiterscheiben, und die Strahlungsenergiequelle zudem sehr aufwendig und teuer ist. Insbesondere für den Einsatz in der Fertigung ist einExcimerlaser problematisch, da er für einen Dauerbetrieb ungeeignet ist und zum Betreiben sehr teure Füllgase eingesetzt werden müssen.

Der Erfindung liegt die Aufgabe zugrunde, ein einfaches, schnelles und preiswertes Verfahren zur Herstellung eines mikroelektronischen Bauelements aus einem Halbleitermaterial, insbesondere Siliziumkarbid, anzugeben, bei dem eine weitgehende Ausheilung von Gitterschäden und ein hoher Aktivierungsgrad von Dotanden erzielt wird, ohne daß das gesamte Volumen des Halbleiterkörpers in einer Ofenumgebung auf Temperaturen über 1000°C erhitzt werden muß.

Die Aufgabe wird durch die Merkmale des unabhängigen Anspruchs gelöst. Weiterführende und vorteilhafte Ausgestaltungen sind den weiteren Ansprüchen und der Beschreibung zu entnehmen.

Die Erfindung besteht darin, den Halbleiter an seiner Oberfläche im wesentlichen ganzflächig durch Einwirken von optischer Strahlung zu bestrahlen und zumindest im dotierten Bereich zu erhitzen, wobei jeder Ort der mit Strahlung beaufschlagten Oberfläche zur gleichen Zeit bestrahlt wird. Dabei ist es besonders günstig, eine Wellenlänge oder einen Wellenlängenbereich zu wählen, in dem der Halbleiter ein erhöhtes Absorptionsvermögen für die betreffende Strahlung aufweist.

Geeignete Strahlungsquellen sind Edelgas-Hochdrucklampen oder Metalldampf-Hochdrucklampen. Eine besonders geeignete Strahlungsquelle ist eine Xenon-Hochdrucklampe, insbesondere eine Xe-Blitzlichtlampe. Günstige Pulslängen liegen im Bereich von Millisekunden bis Sekunden. Der besondere Vorteil liegt darin, daß die auszuheilenden Oberflächenbereiche des Halbleiters in einem einzigen Schritt, insbesondere mit einem einzigen Lichtpuls, ausgeheilt werden können.

In einer bevorzugten Ausfiihrung wird ein ionenimplantiertes Halbleitermaterial in einer Schutzgasatmosphäre, insbesondere einer argonhaltigen Atmosphäre, bestrahlt. Es ist auch möglich, ein ionenimplantiertes Halbleitermaterial in einer Vakuumatmosphäre zu bestrahlen. Damit wird vorteilhaft eine unerwünschte Oxidation und/oder Kontamination des erhitzten Halbleitermaterials vermieden. In einer weiteren bevorzugten Ausbildung des erfindungsgemäßen Verfahrens wird ionenimplantiertes Halbleitermaterial in einer Atmosphäre bestrahlt, in der ein gegenüber Umgebungsbedingungen erhöhter Partialdruck einer oder mehrerer flüchtiger Komponenten des Halbleitermaterials vorgegeben ist. Damit wird ein Schutz vor einer Degradation der Halbleitereigenschaften wegen Materialverlust des Materials oder wegen einer Zersetzung des Materials erreicht.

Besonders geeignet ist das Verfahren für Halbleiter, die nach einer Ionenimplantation ein erhöhtes Absorptionsvermögen für einen Bereich von elektromagnetischer Strahlung auf weisen, während das ungestörte Halbleitermaterial in diesem Bereich keine erhöhte Absorption aufweist, insbesondere Siliziumkarbid. In diesem Fall werden nichtimplantierte und damit ungestörte Gebiete des Halbleiters nicht so stark erhitzt wie die implantierten Bereiche, welche ausgeheilt werden sollen. Unterscheidet sich das Absorptionsvermögen in einem implantierten Bereich nicht oder nur geringfügig von dem Absorptionsvermögen im ungestörten Bereich, ist eine Abdeckung des ungestörten Bereichs vorteilhaft, um die Wärmeeinwirkung auf den gewünschten implantierten Bereich zu beschränken.

In einer bevorzugten Ausführung wird ein Halbleitermaterial nach einer Ionenimplantationsbehandlung in eine Bestrahlungskammer eingebracht und dort mit Licht bestrahlt.

In einer bevorzugten Ausführung wird ein Halbleitermaterial bei erhöhter Substrattemperatur zwischen Raumtemperatur und 1200°C. bevorzugt bei etwa 800°C, besonders bevorzugt bei etwa 400°C. mit Ionenimplantation behandelt und unmittelbar darauf bei derselben Temperatur oder nahe der Implantationstemperatur in derselben Bestrahlungskammer mit Licht bestrahlt.

Die Erfindung wird anhand von in den Figuren dargestellten Ausführungsbeispielen erläutert. Es zeigen
- Fig. 1: einen Vergleich elektrischer Materialparameter von gemäß dem Stand der Technik und gemäß der Erfindung behandeltem Siliziumkarbid mit einer ersten Dotierungsart, und
- Fig. 2: einen Vergleich elektrischer Materialparameter von gemäß dem Stand der Technik und gemäß der Erfindung behandeltem Siliziumkarbid mit einer zweiten Dotierungsart.

Im folgenden ist die Erfindung im wesentlichen anhand von Siliziumkarbid (SiC) als Halbleitermaterial beschrieben. Die. Erfindung kann jedoch auch für andere Halbleitermaterialien, wie andere Mischkristalle, Silizium oder andere Materialien verwendet werden und ist nicht auf Siliziumkarbid eingeschränkt.

Um einen gewünschten Leitungstyp in einem Halbleitermaterial zu realisieren, ist es erforderlich, einen Halbleiter nach einer erfolgten Ionenimplantation von Dotanden auszuheilen. Dabei werden die durch die Implantation erzeugten Schäden im Kristallgitter des Halbleitermaterials ausgeheilt, und die Dotanden gelangen auf elektrisch aktive Gitterplätze. Die nach der Ausheilung optimal erreichbaren Werte elektrischer Eigenschaften wie spezifischer Widerstand oder Ladungsträgerkonzentration sind abhängig von der Menge der bei der Implantation eingebrachten Dotanden. Dabei spielt zum einen die maximale Löslichkeit der Dotanden im Halbleitermaterial als auch die Diffusionskonstante der Dotanden bei der Ausheiltemperatur eine wichtige Rolle. Sollen möglichst hohe Ladungsträgerkonzentrationen und ein geringer spezifischer Widerstand erzielt werden, so wird zweckmäßigerweise eine Konzentration von Dotanden implantiert, die bei einer vorgesehenen Ausheiltemperatur noch löslich ist. Ein wesentlicher Überschuß von Dotanden führt dagegen nicht zu einer weiteren Verbesserung der gewünschten elektrischen Eigenschaften und kann im ungünstigen Fall eher zu einer Verschlechterung führen, da die überschüssigen Dotanden zumindest zusätzliche Streuzentren im Kristallgitter des Halbleiters darstellen.

Zum Ausheilen des Halbleitermaterials sind hohe Temperaturen erforderlich. Ein Halbleiter wie Siliziumkarbid wird dazu bei Temperaturen zwischen 1500°C bis zu etwa 1800°C in einem Ofen getempert. Üblicherweise wird die Temperaturbehandlung in Schutzgasatmosphäre durchgeführt, um einer Oxidation des Halbleitermaterials vorzubeugen. Typische Ausheilzeiten liegen zwischen 5 und 30 Minuten.

Die Löslichkeitsgrenze von Dotanden ist zum einen unterschiedlich für verschiedene Dotanden und zum anderen abhängig von der Ausheiltemperatur, die beim Ausheilen der Strahlenschäden angewendet wird. Meist unterscheiden sich die Löslichkeitsgrenzen auch für unterschiedliche Polytypen eines Halbleitermaterials. Bei Siliziumkarbid sind die Löslichkeitsgrenzen für SiC-Polytypen in etwa gleich. Für Aluminium liegt die Löslichkeit in SiC bei etwa 1·10²⁰ cm⁻³ bei 1700°C und bei etwa 1·10²¹ cm⁻³ bei 2300°C.

Ein bevorzugtes Halbleiterbauelement weist eine epitaktische Siliziumkarbidschicht des 6H-Polytyps auf, die auf einem Substrat aus 6H-SiC abgeschieden ist. Ein weiteres bevorzugtes Halbleiterbauelement weist eine epitaktische Siliziumkarbidschicht des 4H-Polytyps auf, die auf einem Substrat aus 4H-SiC abgeschieden ist. Ein weiteres bevorzugtes Halbleiterbauelement weist eine heteroepitaktische Siliziumkarbidschicht des 3C-Polytyps auf. Als Substrat ist einkristallines Silizium geeignet oder ein SiC-Einkristall des 4H- oder 6H-Polytyps. Eine günstige Schichtdicke liegt zwischen 0,1 µm und 50 µm. Bei einem weiteren bevorzugten Bauelement wird ein SiC-Substrat, insbesondere des 4H- oder 6H-Polytyps, unmittelbar ohne zusätzliche SiC-Schicht verwendet. Einkristallines Siliziumkarbid, welches undotiert oder hochkompensiert, insbesondere semiisolierend ist, ist optisch weitgehend transparent.

In das SiC-Material werden anschließend Dotanden mittels Ionenimplantation eingebracht vorzugsweise Aluminium oder Bor für p-leitendes Material oder Stickstoff oder Phosphor für n-leitendes Material. Die Implantation wird in einem bevorzugten Temperaturbereich zwischen Raumtemperatur und 1100°C durchgeführt. Eine günstige Implantationstemperatur liegt bei etwa 300°C, eine weitere günstige Implantationstemperatur liegt bei etwa 500°C. Eine weitere günstige Implantationstemperatur liegt bei etwa 600°C. Die implantierten Konzentrationen liegen für ein bevorzugtes Dotiermaterial Aluminium im Bereich etwa zwischen 10¹⁸ und 10²¹ cm⁻³. Eine maximale implantierte Aluminiumkonzentration liegt bei etwa 1,5- 10²¹ cm⁻³. Je nach verwendeter Implantationsenergie und verwendetem Implantationsprofil kann dabei ein vergrabener implantierter Bereich unterhalb der Oberfläche der Halbleiterschicht ausgebildet werden.

Eine geringe Aluminiumkonzentration von 5.10¹⁹ cm⁻³ wird mit einem günstigen Implantationsprofil mit folgenden Implantationsparametern erzielt:
1,7·10¹⁵ cm⁻² bei 450 keV
8·10¹⁴ cm⁻² bei 240 keV
5·10¹⁴ cm⁻² bei 120 keV
2,6·10¹⁴ cm⁻² bei 50 keV.

Eine hohe Aluminiumkonzentration von 1,5.10²¹ cm⁻³ wird mit einem günstigen Implantationsprofil mit folgenden Implantationsparametern erzielt:
5·10¹⁶ cm⁻² bei 450 keV
2,4·10¹⁶ cm⁻² bei 240 keV
1,5·10¹⁶ cm⁻² bei 120 keV
8·10¹⁵ cm⁻² bei 50 keV.

Damit ergibt sich jeweils ein vergrabener implantierter Bereich in einer Tiefe von etwa 100-600 nm unterhalb der SiC-Oberfläche.

Soll dieser hochdotierte Bereich des Bauelements später insbesondere zur ohmschen Ankontaktierung von Elektroden oder für andere Strukturen im Halbleiterbauelement verwendet werden, ist es notwendig, den vergrabenen Bereich freizulegen. Dies kann nach dem Ausheilen durch chemische oder physikalische Ätzverfahren, wie z.B. Trockenätzen (RIE), erfolgen. Ein besonders günstiges Verfahren ist, das Material unmittelbar beim Ausheilschritt abzutragen. Es ist günstig, vor einer Ionenimplantation die Oberfläche der SiC-Schicht mit einer Maskierung zu versehen, so daß Dotanden nur in gewünschte Bereiche der Schicht implantiert werden, während keine Dotanden in die durch die Maskierung abgedeckten Bereiche implantiert werden. Die Maskierung kann entweder über eine geeignete Abdeckung erfolgen oder durch eine mit üblichen, insbesondere photolithographischen Mitteln hergestellte, strukturierte Schicht aus Oxid oder Metall sein, die auf die Schichtoberfläche abgeschieden wurde und nach der Implantation oder nach der Ausheilung entfernt wird. In einer günstigen Weiterbildung des erfindungsgemäßen Bauelements ist die Maskierung als Bestandteil des Halbleiterbauelements vorgesehen, insbesondere als Isolierschicht, und verbleibt auf der SiC-Oberfläche. Die Ionenimplantation kann bei Raumtemperatur oder bei einer leicht erhöhten Temperatur insbesondere zwischen Raumtemperatur und 1200°C, insbesondere zwischen Raumtemperatur und 1000°C durchgerührt werden. Der Vorteil einer erhöhten Implantationstemperatur liegt darin, daß Strahlenschäden zumindest teilweise bereits bei der Implantation ausgeheilt werden können Insbesondere bei SiC wird die spätere Aktivierung der Dotanden günstig beeinflußt. Die bei der Implantation vorgesehene Heiztemperatur des Halbleiters ist jedoch deutlich geringer als diejenige Temperatur, die zum Ausheilen und Aktivieren der Dotanden notwendig ist.

Nach der Implantation zeigt Siliziumkarbid im implantierten Bereich eine Verfärbung, die auf eine Schädigung des Kristallgitters zurückzuführen ist. Die Verfärbung ist unter anderem abhängig von der implantierten Dosis und der Implantationstemperatur. Ein n-leitendes, nicht ausgeheiltes SiC ist bei n⁺⁻-Dotierung geschwärzt und undurchsichtig, bei n'-Dotierung hellgrün und transparent. Wird die Dotierung des Materials gut kompensiert, so daß das SiC semiisolierend ist, so wird das Material wieder transparent. Bei p-dotiertem, nicht ausgeheiltem SiC zeigt das Material bei p⁺⁺-Dotierung eine bläulich-graue Färbung und ist trübe, bei nicht ausgehcitter p'-Dotierung ist das Material graublau und transparent.

Gemäß der Erfindung wird das implantierte Bauelement anschließend an die Implantation mit einem Lichtpuls bestrahlt. Eine besonders günstige Bestrahlungsquelle stellt dabei eine Beitzlichtlampe mit im wesentlichen weißen Licht dar, insbesondere Edelgas-Hochdrucklampen oder Metalldampf-Hochdrucklampen. Besonders geeignet ist eine Xenon-Hochdrucklampe oder eine Anordnung von mehreren solchen Lampen. Die Bestrahlung erfolgt vorzugsweise mit einem einzigen Puls von 1-100 ms Dauer, besonders bevorzugt von 10 ms bis 50 ms Dauer. Eine günstige Leistung liegt oberhalb von etwa 10 J/cm². In einem Ausführungsbeispiel wird ein Blitz einer Xe-Hochdrucklampe von etwa 20 ms Dauer und einer integrierten Energie pro Puls von etwa 100 J/cm² verwendet. Die Energiedichte wurde dabei aus Schmelztestversuchen von Silizium unter Berücksichtigung des Reflexionsfaktors für das einfallende Licht und der Dicke der verwendeten SiliziumScheibe, etwa 250 µm, abgeschätzt.

Besonders vorteilhaft ist, daß die Lichtquelle mittels geeigneter optischer Mittel so aufgestreut werden kann, daß das Bauelement über seine gesamte Fläche gleichzeitig ausgeleuchtet werden kann. Die Lichtquelle kann auch aus mehreren Lampen gebildet werden. Bei SiC ist eine Energiedichte um etwa 100 J/cm² sehr günstig. Mit einem Lampenarray von mehreren Xenon-Hochdrucklampen können Flächen bis zu 10 cm (4") Durchmesser mit einem einzigen Lichtpuls ausgeheilt werden. Größere Flächen können bestrahlt werden, indem mehr Lampen zusammengefaßt werden, so daß eine kritische Energiedichte an jedem Punkt im Strahlungsfeld, welches auf eine zu bestrahlende Fläche trifft, über einer kritischen Grenze der Energiedichte liegt, welche bei SiC nach der bereits beschriebenen Bestimmungsmethode unterhalb von 100 J/cm² liegt. Die günstigste Energiedichte hängt dabei auch von der Temperatur ab. welche das Bauelement bei der Bestrahlung aufweist wie auch von der Dicke der zu bestrahlenden Schicht und/oder der Tiefe der Schicht im Halbleiter im Falle von vergrabenen dotierten Schichten. Die Bestrahlungsparameter werden zweckmäßigerweise an diese Bedingungen angepaßt. Bei besonders stark erhöhter Absorption der Strahlung und/oder bei besonders energiereicher Strahlung ist eine Pulslänge von Picosekunden bis Millisekunden günstig.

Neben der vorteilhaften Zeitersparnis beim Ausheilen der Strahlenschäden gemäß der Erfindung entfällt auch eine aufwendige Anordnung zum lateralen Verschieben eines Lichtstrahls, um eine Bauelementfläche gleichmäßig mit einem Lichtstrahl abzurastern, wie dies z.B. mit einem Laser notwendig ist. Auch ist es nicht einfach, jeden Bereich der Oberfläche mit gleicher Lichtintensität und Energie zu bestrahlen, wenn ein Licht- und/oder Laserstrahl zeilenweise über eine zu bestrahlende Fläche geführt wird, da insbesondere an Überlappungsgebieten von bestrahlten Zeilen auf der Oberfläche keine definierten Energieeinträge durch den Rasterstrahl erfolgen kann. Dies gilt insbesondere für bestrahlte Materialien, die bei höheren Temperaturen einen Materialverlust durch Sublimation oder Abdampfen von Konstituenten erleiden. Weitcrhin werden unerwünschte Effekte im Halbleiter vermieden, die an Rändern des jeweils beleuchteten, lokal begrenzten Gebiets in Zonen mit abnehmender Lichtintensität entstehen können und eine Ausheilung des Halbleitergitters und eine Aktivierung der Dotanden erschweren.

Bevorzugt wird das Bauelement zur Bestrahlung in eine Schutzgasatmosphäre eingebracht, um eine Oxidation des Halbleitermaterials zu vermeiden. Je nach Halbleitermaterial besteht eine geeignete Schutzgasatmosphäre insbesondere aus Argon. Stickstoff. Wasserstoff oder Formiergas. Zweckmäßigerweise wird die Atmosphäre so gewählt, daß der Halbleiter nicht durch das Schutzgas in unerwünschter Weise kontaminiert wird. Die Bestrahlung kann bei Raumtemperatur durchgeführt werden. Das Bauelement wird nicht gezielt weiter erhitzt. Eine besonders günstige Ausführung ist, das Bauelement auf eine Kühlfläche zu montieren, um die nichtimplantierten Bereiche des Bauelements vor Wärmeeinwirkung beim lokalen Ausheilen zu schützen.

Eine weitere günstige Ausführung ist, das Bauelement beim Ausheilschritt auf eine relativ geringe Temperatur zwischen Raumtemperatur und 600°C zu erwärmen. Die maximale Temperatur liegt jedenfalls wesentlich unterhalb der sonst zur Ausheilung üblichen Temperatur von bis zu 2000°. Dies ist ganz besonders dann vorteilhaft, wenn das Bauelement unmittelbar anschließend an die Implantation der Dotanden mit dem Licht bestrahlt wird und die Implantation bei einer erhöhten Temperatur, insbesondere zwischen 400°C und 700°C, durchgefiihrt wird. Dazu ist es ganz besonders vorteilhaft, wenn das SiC vor der Implantation mit einer Maskierung versehen und demnach strukturiert implantiert wird. Der besondere Vorteil ist, daß sowohl für die Implantation, welche bei moderat erhöhten Temperaturen durchgeführt wird, als auch für die Ausheilung des implantierten Bauelements kein separater Ofen notwendig ist. Gegebenenfalls kann die Bestrahlung direkt in der Implantationskammer durchgeführt werden, wobei eine optische Einkopplung in die Bestrahlungskammer vorzusehen ist, und welche vorzugsweise vor der Ausheilung mit einer geeigneten Atmosphäre auf einen vorgegebenen Druck geflutet wird. Eine eigene Bestrahlungskammer ist dann nicht notwendig. Damit sind erhebliche Einsparungen an Prozeßzeit und Anlagenkosten möglich.

Je nach Lichtquelle und Intensität kann eine Bestrahlungsdauer zwischen einigen Sekunden und Picosekunden eingestellt werden. Dabei können mehrere Pulse hintereinander oder längere Pulse zur Bestrahlung eingesetzt werden. Die Parameter sind für verschiedene Halbleitermaterialien und Dotanden sowie für die jeweilige Bestrahlungsquelle anzupassen. Vorzugsweise ist die Bestrahlung möglichst kurz, da dann die thermische Belastung des Bauelements insgesamt vorteilhaft verringert ist.

Der elektromagnetische Strahlungspuls kann die SiC-Oberfläche des Bauelements ganzflächig bestrahlen. Besonders vorteilhaft ist, eine Lichtquelle mit einem Spektrum zu wählen, das eine erhöhte Intensität in dem Wellenlängenbereich aufweist, in dem die optische Absorption des Halbleitermaterials hoch ist, insbesondere nach der Implantation. Bei SiC zeigt die Verfärbung des Materials nach der Implantation eine erhöhte optische Absorption wegen der Strahlenschäden an. Falls keine Unterschiede in der optischen Absorption eines gestörten und ungestörten Halbleiters vorliegen, ist es vorteilhaft, die gewünschten Bereiche mit einer geeigneten Maskierung zu versehen, so daß nur die auszuheilenden Bereiche des Halbleiters bestrahlt werden.

Der implantierte SiC-Bereich ist nach der Bestrahlung mit elektromagnetischer Strahlung wieder klar und transparent. Aus Aktivierungs- und Beweglichkeitsmessungen der Ladungsträger wird geschlossen, daß die kurzzeitige Bestrahlung im implantierten Bereich der SiC-Schicht kurzzeitig und lokal wirkende effektive Temperatur von bis etwa 2000°C verursacht, obwohl das Bauelement selbst nicht weiter erhitzt wurde oder allenfalls auf einer erheblich niedrigeren Temperatur unter 1000°C, bevorzugt nahe der Implantationstemperatur gehalten wurde.

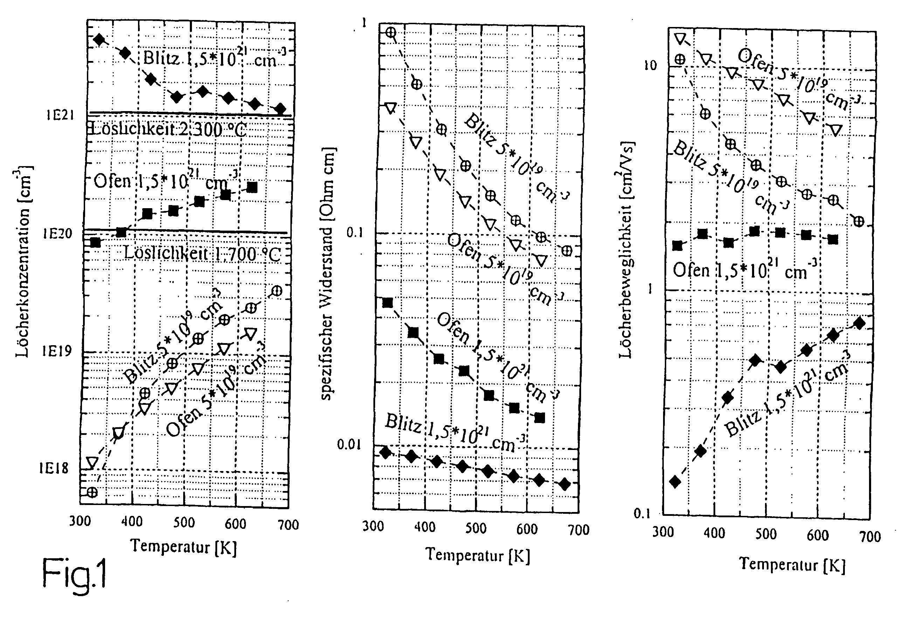

In Fig. 1 ist einen Vergleich elektrischer Materialparameter von gemäß dem Stand der Technik und gemäß der Erfindung behandeltem Siliziumkarbid mit einer Aluminiumdotierung für zwei Konzentrationen von 5·10¹⁹ cm⁻³ und 1,5·10²¹ cm⁻³ dargestellt. Als Materialparameter sind jeweils Löcherkonzentration, spezifischer Widerstand und Löcherbeweglichkeit als Funktion der Temperatur dargestellt. Die Ausheilung des Vergleichs-Bauelements gemäß dem Stand der Technik erfolgt in einer zehnminütigen Ofentemperung in Argonatmosphäre bei einer Ausheiltemperatur von 1650°C.

Die Parameter für beide Ausheilarten unterscheiden sich bei einer geringen Aluminiumdotierung von 5.10¹⁹ cm⁻³ praktisch nicht voneinander. Die Ladungsträgerkonzentration (Löcher) ist für beide Verfahren unterhalb der Löslichkeitsgrenze von 1.10²⁰ cm⁻³ bei 1700°C und steigt mit der Temperatur in einer dem Fachmann bekannten Weise an. Die ertindungsgemäße Behandlung erlaubt jedoch eine beträchtliche Einsparung von Prozeßzeit und Aufwand gegenüber einer zeit- und eneruieautwendigen Ofenbehandlung. Außerdem ist die thermische Belastung des Bauelements insgesamt schonender als bei einer Ofenbehandlung.

Dagegen sind Löcherkonzentration und spezifischer Widerstand bei einer sehr hohen Dotierung von 1,5·10²¹ cm⁻³ mit dem erfindungsgemäßen Verfahren deutlich überlegen. Die gemessene Löcherkonzentration des erfindungsgemäß behandelten Bauelements ist eine Größenordnung höher; der spezifische Widerstand ist um einen Faktor fünf geringer als bei der Vergleichsprobe mit Ofenbehandlung. Bei der optischen Strahlungseinwirkung war die Bauelementtemperatur durch eine Ofenheizung lediglich bei einer Heiztemperatur von etwa 600°C. Im Gegensatz zu der gemäß dem Stand der Technik behandelten Vergleichsprobe zeigt sich sogar ein metallisches Verhalten bei der erfindungsgemäß behandelten Probe. Die Löcherkonzentration entspricht darüber hinaus im wesentlichen der maximal möglichen Konzentration an der Löslichkeitsgrenze von 2000°C. Eine solche vorteilhaft hohe Löcherkonzentration ist mit üblichen Ofenbehandlungen im thermodynamischen Gleichgewicht nicht erzielbar.

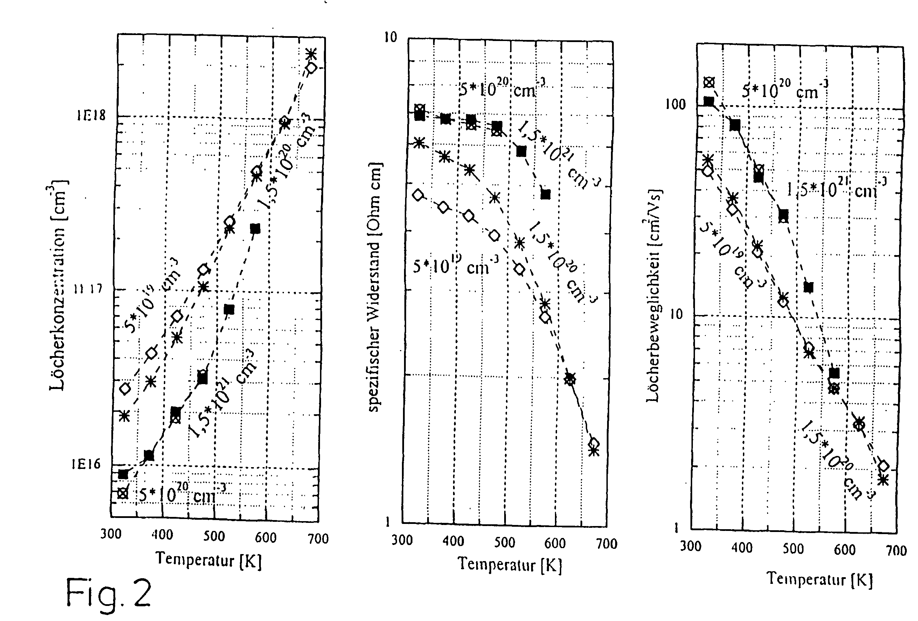

In Fig. 2 sind Ergebnisse für eine weitere Dotierungsart in SiC dargestellt. Als Dotand wurde Bor in vergleichbarer Konzentration und Fluenz wie in Fig. 1 für Aluminium verwendet. Wie die Kennlinien zeigen, gibt es keine signifikanten Unterschiede zwischen erfindungsgemäß ausgeheiltem SiC-Material und mit üblicher Ofenbehandlung ausgeheiltem SiC. Die Ausheilung gemäß der Erfindung ist hinsichtlich der Ausheilung und Aktivierung der Dotanden dem bekannten Verfahren zumindest gleichwertig.

Weitergehende Untersuchungen von Tiefenpronlen von ausgeheilten SiC-Proben mit Sekundärionen-Massenspektrometrie zeigen, daß insbesondere die Aluminiumkonzentration sowohl nach der Blitz- als auch nach der Ofenbehandlung keine signifikanten Verlagerungen zeigt.

Eine weitere bevorzugte Ausführung besteht darin, die Ausheilung der implantierten SiC-Schicht nicht in einer Schutzgasatmosphäre durchzuführen, sondern im Vakuum. Da SiC bei Temperaturen oberhalb von etwa 1200°C einen mit der Temperatur stark ansteigenden Siliziumverlust und/oder Kohlcnstoffverlust durch Sublimation erleidet, kann als Atmosphäre auch eine Vakuumumgebung gewählt werden, in der mindestens ein erhöhter Partialdruck der flüchtigen Komponente des Halbleiters, insbesondere Silizium oder SiC bei Siliziumkarbid, eingestellt ist. Damit wird ein Abtrag von der SiC-Oberfläche vermieden. Zweckmäßigerweise wird das Bauelement in einen SiC-Tiegel gelegt und optisch bestrahlt.

Eine weitere bevorzugte Ausführung besteht darin, bei der Bestrahlung des implantierten SiC-Bereichs gleichzeitig die Oberfläche der SiC-Schicht gezielt abzutragen und den vorher vergrabenen dotierten Bereich freizulegen. Dazu wird das Bauelement während des Ausheilschritts vorzugsweise in eine Vakuumumgebung eingebracht, deren Gesamtdruck vorzugsweise geringer als 10⁻³ Pa ist. Der SiC-Abtrag durch Sublimation ist temperaturabhängig und läßt sich durch Partialdruck und Temperatur gezielt steuern. Bei der Bestrahlung kann auch durch eine Variation der Wellenlänge und der Pulsdauer der elektromagnetischen Strahlung die Abtragsrate beeinflußt und ein definierter Abtrag von der Oberfläche ermöglicht werden. Damit gelingt ein gezieltes Freilegen eines vergrabenen dotierten Bereichs. Der besondere Vorteil ist, daß die Ausheilung und das Freilegen des dotierten vergrabenen Bereichs in einem einzigen Prozeßschritt möglich ist. SiC-Schichten, die mit einem Puls von 20 ms Dauer einer Xe-Hochdrucklampe in Argonatmosphäre bestrahlt wurde, zeigen typischerweise einen Oberflächenabtrag von etwa 100 nm.

## Patentansprüche

1. Verfahren zur Herstellung eines mikroelektronischen Halbleiter-Bauelementes, wobei im Halbleiter dotierte Bereiche durch lonenimplantation hergestellt und Strahlenschäden im Halbleiter anschließend durch Bestrahlung mit elektromagnetischer Strahlung ausgeheilt werden, und der Halbleiter an seiner Oberfläche im wesentlichen ganzflächig durch Einwirken von optischer Strahlung bestrahlt und zumindest im dotierten Bereich erhitzt wird, wobei jeder Ort der mit Strahlung beaufschlagten Oberfläche zur gleichen Zeit bestrahlt wird,
**dadurch gekennzeichnet,**
**daß** die Bestrahlung in einer Atmosphäre durchgeführt wird, in der ein gegenüber Umgebungsbedingungen erhöhter Partialdruck einer oder mehrerer flüchtiger Komponenten des Halbleitermaterials vorgegeben ist.

2. Verfahren nach Anspruch 1,
**dadurch gekennzeichnet,**
**daß** der Halbleiter mit Strahlung einer oder mehrerer Gas- und/oder Dampf Hochdrucklampen bestrahlt wird.

3. Verfahren nach Anspruch 1 oder 2,
**dadurch gekennzeichnet,**
**daß** der Halbleiter mit einem optischen Puls mit einer Dauer im Bereich von 1 bis 100 Millisekunden bestrahlt wird.

4. Verfahren nach einem oder mehreren der Ansprüche 1 bis 3,
**dadurch gekennzeichnet,**
**daß** eine vorgegebene Dicke einer Oberflächenschicht im bestrahlten Bereich durch Einwirken von elektromagnetischer Strahlung auf den Halbleiter abgetragen wird.

5. Verfahren nach einem oder mehreren der Ansprüche 1 bis 4,
**dadurch gekennzeichnet,**
**daß** für das Bauelement ein Halbleiter-Mischkristall verwendet wird.

6. Verfahren nach einem oder mehreren der Ansprüche 1 bis 5,
**dadurch gekennzeichnet,**
**daß** als Halbleiter Siliziumkarbid verwendet wird.

7. Verfahren nach einem oder mehreren der Ansprüche 1 bis 5,
**dadurch gekennzeichnet,**
**daß** als Halbleiter Silizium verwendet wird.

8. Verfahren nach einem oder mehreren der Ansprüche 1 bis 7,
**dadurch gekennzeichnet,**
**daß** das Halbleiterbauelement in eine Bestrahlungskammer eingebracht wird, dort auf eine erste vorgegebene Heiztemperatur gebracht und gehalten wird, daß dann Dotierstoffe mit lonenimplantation in das Halbleiterbauelement eingebracht werden, daß das Halbleiterbauelement anschließend bei einer zweiten vorgegebenen Heiztemperatur mit optischer Strahlung beaufschlagt und anschließend aus der Bestrahlungskammer entfernt wird, wobei eine obere Heiztemperatur von 1200°C nicht überschritten wird.

9. Verfahren nach einem oder mehreren der Ansprüche 1 bis 7,
**dadurch gekennzeichnet,**
**daß** das Halbleiterbauelement nach der lonenimplantation in eine Bestrahlungskammer eingebracht wird, dort auf eine vorgegebene erste Heiztemperatur gebracht und gehalten wird, daß das Halbleiterbauelement dann mit optischer Strahlung beaufschlagt und anschließend aus der Bestrahlungskammer entfernt wird, wobei eine obere Heiztemperatur von 1200°C nicht überschritten wird.

10. Verfahren nach einem oder mehreren der Ansprüche 1 bis 9,
**dadurch gekennzeichnet,**
**daß** eine obere Heiztemperatur von 800°C nicht überschritten wird.

11. Verfahren nach einem oder mehreren der Ansprüche 1 bis 10,
**dadurch gekennzeichnet,**
**daß** das Halbleiterbauelement vor der Implantation und/oder vor der optischen Bestrahlung mit einer entfernbaren Maskierung versehen wird.

12. Verfahren nach einem oder mehreren der Ansprüche 1 bis 11,
**dadurch gekennzeichnet,**
**daß** das Halbleiterbauelement vor der Implantation und/oder vor der optischen Bestrahlung mit einer festen Maskierung versehen wird.

13. Verfahren nach einem oder mehreren der Ansprüche 1 bis 12,
**dadurch gekennzeichnet,**
**daß** der Halbleiter bei einem Druck unterhalb von Atmosphärendruck bestrahlt wird.

14. Verfahren nach einem oder mehreren der Ansprüche 1 bis 13,
**dadurch gekennzeichnet,**
**daß** die optische Bestrahlung in einer Schutzgasatmosphäre durchgeführt wird.

## Revendications

1. Procédé de fabrication d'un composant microélectronique à semi-conducteur, dans lequel on réalise dans le semi-conducteur des zones dopées par implantation d'ions et on répare ensuite par irradiation par un rayonnement électromagnétique les zones du semi-conducteur qui ont été endommagées par le rayonnement, essentiellement la totalité de la surface du semi-conducteur étant irradiée par un rayonnement optique et le semi-conducteur étant chauffé au moins dans la zone dopée, tous les points de la surface irradiée par le rayonnement étant irradiés simultanément,
**caractérisé en ce que** l'irradiation est réalisée dans une atmosphère dans laquelle on définit une pression partielle d'un ou plusieurs composants volatils du matériau semi-conducteur qui est plus élevée que dans les conditions de l'ambiance.

2. Procédé selon la revendication 1, **caractérisé en ce que** le semi-conducteur est irradié par le rayonnement d'une ou de plusieurs lampes à haute pression de gaz ou de vapeur.

3. Procédé selon les revendications 1 ou 2, **caractérisé en ce que** le semi-conducteur est irradié par une impulsion optique d'une durée de l'ordre de 1 à 100 millisecondes.

4. Procédé selon une ou plusieurs des revendications 1 à 3, **caractérisé en ce que** dans la zone irradiée, une épaisseur prédéterminée d'une couche de surface est enlevée du semi-conducteur par l'action du rayonnement électromagnétique.

5. Procédé selon une ou plusieurs des revendications 1 à 4, **caractérisé en ce que** pour le composant, on utilise un cristal semi-conducteur mixte.

6. Procédé selon une ou plusieurs des revendications 1 à 5, **caractérisé en ce que** comme semi-conducteur, on utilise le carbure de silicium.

7. Procédé selon une ou plusieurs des revendications 1 à 5, **caractérisé en ce que** comme semi-conducteur, on utilise le silicium.

8. Procédé selon une ou plusieurs des revendications 1 à 7, **caractérisé en ce que** le composant semi-conducteur est placé dans une chambre d'irradiation dans laquelle il est amené et maintenu à une première température prédéterminée de chauffage, **en ce que** les substances de dopage sont ensuite incorporées dans le composant semi-conducteur par implantation d'ions, **en ce que** le composant semi-conducteur est ensuite irradié à une deuxième température prédéterminée par un rayonnement optique pour être ensuite retiré de la chambre d'irradiation, la température supérieure de chauffage ne dépassant pas 1 200°C.

9. Procédé selon une ou plusieurs des revendications 1 à 7, **caractérisé en ce que** le composant semi-conducteur est placé dans une chambre d'irradiation après l'implantation d'ions, y est amené et maintenu à une première température prédéterminée de chauffage, **en ce que** le composant semi-conducteur est ensuite irradié par un rayonnement optique pour être ensuite retiré de la chambre d'irradiation, la température supérieure de chauffage ne dépassant pas 1 200°C.

10. Procédé selon une ou plusieurs des revendications 1 à 9, **caractérisé en ce que** la température supérieure de chauffage ne dépasse pas 800°C.

11. Procédé selon une ou plusieurs des revendications 1 à 10, **caractérisé en ce qu'**avant l'implantation et/ou avant l'irradiation optique, le composant semi-conducteur est doté d'un masque enlevable.

12. Procédé selon une ou plusieurs des revendications 1 à 11, **caractérisé en ce qu'**avant l'implantation et/ou avant l'irradiation optique, le composant semi-conducteur est doté d'un masque fixe.

13. Procédé selon une ou plusieurs des revendications 1 à 12, **caractérisé en ce que** le composant semi-conducteur est irradié à une pression inférieure à la pression atmosphérique.

14. Procédé selon une ou plusieurs des revendications 1 à 13, **caractérisé en ce que** l'irradiation optique est réalisée dans une atmosphère de gaz protecteur.

## Claims

1. Process for producing a microelectronic semiconductor component, in which doped regions are produced in the semiconductor by ion implantation, and radiation damage in the semiconductor is then annealed by irradiation with electromagnetic radiation, and the semiconductor is irradiated over substantially its entire surface by the action of optical radiation and is heated at least in the doped region, with each location of the surface which is exposed to radiation being irradiated simultaneously, **characterized in that** the irradiation is carried out in an atmosphere in which an elevated partial pressure, compared to ambient conditions, of one or more volatile components of the semiconductor material is preset.

2. Process according to Claim 1, **characterized in that** the semiconductor is irradiated with radiation from one or more gas and/or vapour high-pressure lamps.

3. Process according to Claim 1 or 2, **characterized in that** the semiconductor is irradiated with an optical pulse with a duration in the range from 1 to 100 milliseconds.

4. Process according to one or more of Claims 1 to 3, **characterized in that** a predetermined thickness of a surface layer is removed in the irradiated region by the action of electromagnetic radiation on the semiconductor.

5. Process according to one or more of Claims 1 to 4, **characterized in that** a semiconductor solid solution is used for the component.

6. Process according to one or more of Claims 1 to 5, **characterized in that** the semiconductor used is silicon carbide.

7. Process according to one or more of Claims 1 to 5, **characterized in that** the semiconductor used is silicon.

8. Process according to one or more of Claims 1 to 7, **characterized in that** the semiconductor component is introduced into an irradiation chamber, where it is brought to and held at a first predetermined heating temperature, **in that** dopants are then introduced into the semiconductor component by ion implantation, **in that** the semiconductor component is then acted on by optical radiation at a second predetermined heating temperature and is then removed from the irradiation chamber, without exceeding an upper heating temperature of 1200°C.

9. Process according to one or more of Claims 1 to 7, **characterized in that** the semiconductor component, following the ion implantation, is introduced into an irradiation chamber, where it is brought to and held at a predetermined first heating temperature, **in that** the semiconductor component is then acted on by optical radiation and then removed from the irradiation chamber, without exceeding an upper heating temperature of 1200°C.

10. Process according to one or more of Claims 1 to 9, **characterized in that** an upper heating temperature of 800°C is not exceeded.

11. Process according to one or more of Claims 1 to 10, **characterized in that** the semiconductor component is provided with a removable masking prior to the implantation and/or prior to the optical irradiation.

12. Process according to one or more of Claims 1 to 11, **characterized in that** the semiconductor component is provided with a fixed masking prior to the implantation and/or prior to the optical irradiation.

13. Process according to one or more of Claims 1 to 12, **characterized in that** the semiconductor is irradiated at a pressure which is below atmospheric pressure.

14. Process according to one or more of Claims 1 to 13, **characterized in that** the optical irradiation is carried out in a protective gas atmosphere.
